# EUROPEAN PATENT APPLICATION

(11) **EP 3 021 490 A1**
(43) Date of publication of application: **18.05.2016**
(21) Application number: 15194831.2
(22) Date of filing: 16.11.2015
(51) Int. Cl.: H03M 1/20, H03M 1/12

(54) **DIGITIZER AUTO APERTURE WITH TRIGGERING SPACING**

(30) Priority: 14.11.2014 US 201462079754 P; 12.12.2014 US 201414568904
(71) Applicant: Keithley Instruments, Inc., Cleveland OH 44139 (US)
(72) Inventor: GOEKE, Wayne, Hudson, OH 44236 (US); FRACKELTON, Brian, Macedonia, OH 44056 (US); YURICK, Benjamin, Garrettsville, OH 44231 (US)
(74) Representative: Clarke, Jeffrey David

(57) **Abstract**

A method for producing sampled data, which as the requested sampling period is increased, each sample is the average of an increasing number of ADC samples such that a maximum number of ADC samples are evenly space across the sample period. The method can include choosing one of multiple ADC with varying speed versus resolution capabilities to further increase the quality of the sampled data as the sampling period increases.

## Description

### Technical Field

This disclosure relates generally to digitizers, logic analyzers, and other electronic acquisition systems.

### Background

Logic analyzers generally allow a user to specify a sample rate as an integer multiple of what the hardware can achieve.

Digitizers are similar to logic analyzers and generally allow a user to perform measurements at a specified interval.

Many products currently offer filtering of measurements where the user can specify a filter size or where measured data is filtered behind the scenes.

Certain digital multi-meters (DMMs), such as the 2001 DMM by Keithley Instruments, offers an "auto aperture" feature, but such feature simply involves programming the aperture to get a requested resolution.

Previous DMMs and other test equipment may allow a user to specify a fixed aperture for the analog-to-digital converter (ADC) to measure the inputs to produce a measurement but do not extend beyond such functionality.

Digitizers and other acquisition systems generally allow a user to set a sample rate, which can be implemented as specified. This may be done by definition (i.e., the user may ask for that sample rate). This approach simplifies the implementation since the system doesn't need to deal with any mismatch between the achievable sample rate and what is requested. If the system can acquire data at 1 ns rates, the user may specify the sample rate in 1 ns increments and the sample rate may be so implemented.

Consider an example in which a logic analyzer allows a user to specify a sample rate (e.g., 1 ns in 1 ns increments). Here, the instrument implements exactly what is specified by the user. There is generally too much data in high-speed systems to do much else with it.

Consider another example in which an ADC chip takes a measurement and returns the result as fast as it is triggered. Here, the chip does not attempt to introduce any variable delay behind the scenes as its priority is to output the measurement as soon as possible.

### Brief Description of the Drawings

FIGURE 1 illustrates an example of firmware registers in accordance with certain implementations of the disclosed technology.
FIGURE 2 illustrates an example of a field-programmable gate array (FPGA) state machine in accordance with certain implementations of the disclosed technology.
FIGURE 3 illustrates an example of fixed aperture firmware calculations.

### Detailed Description

Certain embodiments of the disclosed technology include taking a user-requested specified sample rate and producing data at that sample rate (e.g., to the end user) while triggering measurements at another rate behind the scenes to achieve superior accuracy.

In situations where the user-requested sample rate is slower than the fastest rate the hardware can support, the system may oversample and take as many samples as possible within the sample period (1/sample-rate). These sample readings may then be averaged to eliminate noise. Consider an example in which the hardware has a 1 M sample/sec ADC. If asked to run at 500k sample/sec by a user, the algorithm may take two measurements (i.e. sample readings) behind the scenes and average them. If asked for 100k samples/second (i.e. providing a 10µs sampling window), the algorithm may take and average ten sample readings since ten 1µs readings can fit within the 10µs sampling window (also known as sample, or sampling, period).

In situations where more than an integer number of samples fit within the user-requested sample period, the algorithm may take as many measurements as can fit and equally space them to create a consistent background sample rate.

Consider an example assuming a 1µs ADC conversion period (i.e., uses a 1M sample/sec ADC) with a user-requested sample rate of 400kHz. Here, the user-requested sample period is 1/400000 = 2.5µs, and the 2.5µs user-requested sample period can accommodate only two full readings. The algorithm may split up the extra 0.5 µ seconds, for example equally, so that measurements are periodically triggered every 1.25µs (i.e., completely filling the 2.5µs period) and each set of two measurements may be averaged to yield one result to the end user. This may be seen as equivalent to using the ADC at a rate of 0.8Mhz, which is a higher rate of operation, but not quite the maximum rate of operation (of 1 Mhz).

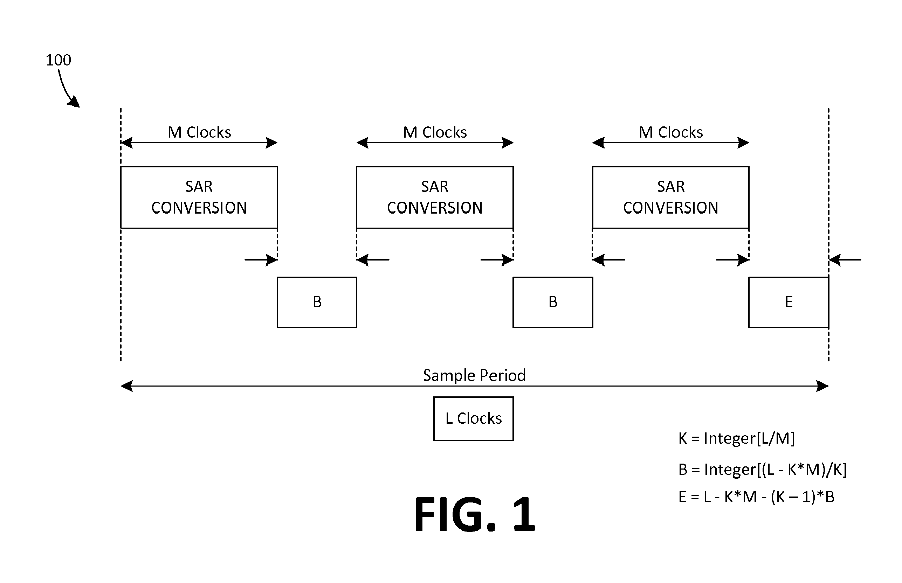

FIGURE 1 illustrates an example of firmware registers 100 in accordance with certain implementations of the disclosed technology, where L refers to the number of clocks per user-requested sample period, K refers to the number of sub-measurements to be averaged per user-requested sample period, M refers to the number of clocks taken by each sub-measurement (i.e. the actual sampling period of the ADC in use), B refers to the number of clocks between the sub-measurements, and E refers to the number of clocks after the final sub-measurement. The user requested sample period is repeated N times, to provide N total number of measurements. In this example, K is defined as the integer value of L/M; B is defined as the integer value of (L-((K*M)/K)); and E is defined as L - (K*M) - ((K-1)*B). FIGURE 1 is shown implemented using a successive-approximation-register (SAR) type ADC.

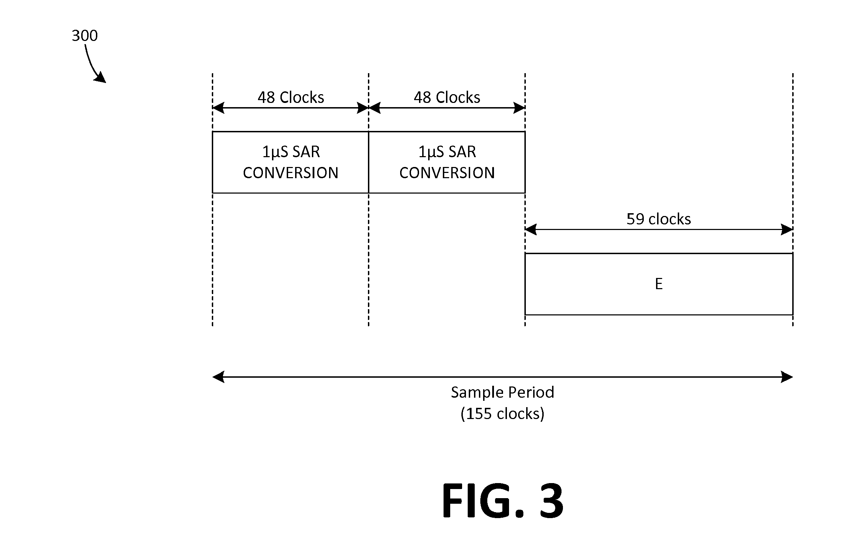

There now follows a description of a specific example implementation of the timing diagram of FIGURE 1, for example using a Field Programmable Gate Array (FPGA) having a 48 Mhz system clock, where the SAR ADC conversion takes 48 clocks to complete (i.e. 1µs). M is therefore 48 clocks, and the ADC is a 1 M sample/sec ADC (also see FIGURE 3).

The user-defined sample period, L, is 155 clocks long (see Figure 3), and in the example, the number of sub-measurements (i.e., K) is three. Using the above equations we get the following results:
K = integer value of (155/48) = int (3.229) = 3;
B = integer value of ((155-3*48)/3) = int (11/3) = 3;
E = 155 - 3*48 - (3-1)3 = 5.

Therefore, FIGURE 1 shows a system where the user has requested a sample rate of approx. 310k sample/sec, using an ADC having 1 M samples/sec capability.

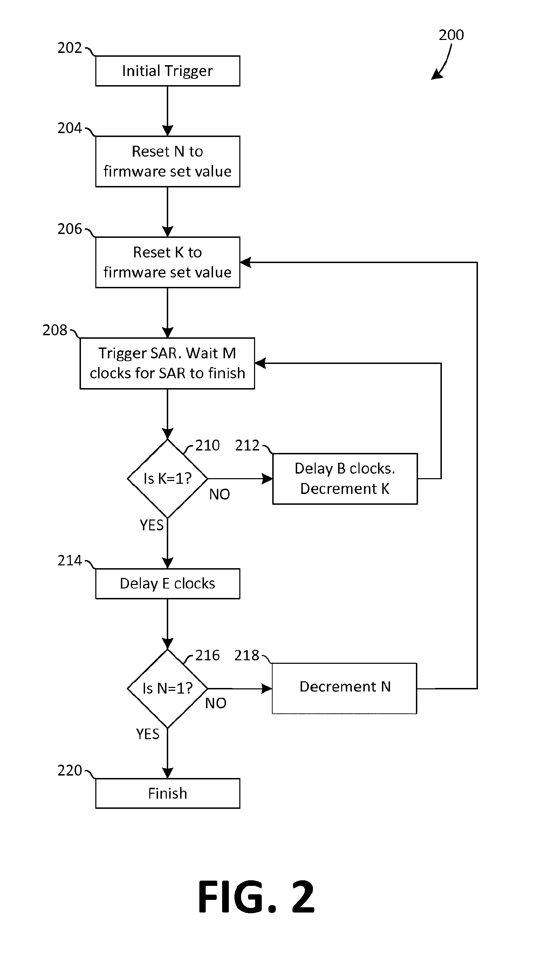

FIGURE 2 is a flow chart illustrating an example of a method 200 in accordance with certain implementations of the disclosed technology.

After an initial trigger at 202, the number of measurements N is reset to its firmware set value, as indicated by 204. The number of sub-measurements K is then reset to its calculated set value, as indicated by 206. The SAR is then triggered and an M-clock pause is implemented to allow the SAR to finish, as indicated by 208. This is because, in this example, the SAR takes M clocks to complete its conversion.

At 210, a determination is made as to whether K is equal to one: if not, a delay of B clocks is implemented and K is decremented (as indicated by 212) and then the method returns to 208; otherwise, a delay of E clocks is implemented (as indicated at 214).

At 216, a determination is made as to whether N is equal to one: if not, N is decremented (as indicated by 218) and then the method returns to 206; otherwise, the process 200 completes, as indicated by 220. In some examples, a delay of B clocks may be implemented at the same time as decrementing N.

By working though the iterative process shown in Figure 2, the method applies K number of sub-measurements per user-defined sample period (i.e. K sub-measurements per N), with delays of B clocks between the K sub-measurements, with a final delay of E clocks to make up the required total number of clocks, per user defined sample period (given a particular system operation frequency).

Certain implementations of the disclosed technology may allow a user to disable the "auto" aperture feature. For example, the subsampling and averaging behind the scenes may be problematic if the application does not want to monitor the input signal between sample points. In such situations, the system may allow a user to program a fixed aperture, such as the fixed aperture firmware calculations 300 illustrated by FIGURE 3.

FIGURE 3 shows a non-auto example where: B = 0, because it shows an example of a fixed aperture case not set to auto; K= 2 (i.e. two conversions shown per sample period); E= 59 clocks; L= 155 clocks (48 clocks per SAR conversion * 2 + 59 clocks). In this example, the user is provided with a reading comprising the average of the two SAR readings, per sample period.

Certain implementations may include intelligence (i.e. logic) to select from more than one ADC to use, given a specified sample rate (e.g., switch from a successive-approximation-register (SAR) ADC to a charge balance ADC). The resulting time/accuracy tradeoff between the two ADC technologies may therefore allow for increased performance of the overall electronic acquisition system. For example, use of a first type of ADC technology until it reaches a point of diminishing returns, at which point the system can switch to use another, second, type of ADC technology and automatically pick that for the user at the appropriate point, i.e. the system may include logic to automatically determine the appropriate switching point between the two ADC technologies to maximum performance based on one or more user-defined system parameters.

Consider a first example in which a product has two ADCs: a SAR ADC with maximum accuracy of 18 bits (i.e., before averaging) and a maximum speed of 1 M readings/sec; and a charge balance ADC with maximum accuracy of around 26 bits and maximum speed of around 20k readings/sec (e.g., 0.0005 Number of Power Line Cycles, NPLC, aperture with rundown overhead). If a user chooses a sample rate that both ADCs can support, the firmware may use a performance table to decide which will yield better results. Since the system is generally averaging to extend the accuracy of the SAR ADC, it can achieve some overlap where the faster SAR may still outperform the slower charge balance ADC at very high sample rates (i.e., very small apertures).

The "auto" aperture approach described herein generally allows the user to achieve superior results without having to think about it.

Certain implementations of the disclosed technology may include an algorithm configured to help bridge the gap between a fast but less accurate ADC (e.g. a SAR ADC) and a slower but more accurate ADC (e.g. a charge balance ADC), noting these ADC selecting embodiments of the invention are not limited to any particular types of ADC technologies. The extra averaging advantageously extends the usability of the faster ADC and makes it possible to create overlap between ADC technologies so that they can be chosen for the user based upon the specified settings.

The following discussion is intended to provide a brief, general description of a suitable machine in which embodiments of the disclosed technology can be implemented, for example providing a machine to be an electronic acquisition system to carry out any of the disclosed methods. As used herein, the term "machine" is intended to broadly encompass a single machine or a system of communicatively coupled machines or devices operating together. Exemplary machines may include computing devices such as personal computers, workstations, servers, portable computers, handheld devices, tablet devices, and the like. The exemplary machines may implement an electronic acquisition system, such as a test and measurement instrument, or portion thereof, for example a logic analyzer, digitizer, digital multi-meter, oscilloscope, or any other electronic acquisition system, or portion thereof.

Typically, a machine according to examples includes a system bus to which processors, memory such as random access memory (RAM), read-only memory (ROM), and other state-preserving medium, storage devices, a video interface, and input/output interface ports can be attached. The machine may also include embedded controllers such as programmable or non-programmable logic devices or arrays, Application Specific Integrated Circuits (ASICs), embedded computers, smart cards, and the like. The machine may be controlled, at least in part, by input from conventional input devices such as keyboards and mice, as well as by directives received from another machine, interaction with a virtual reality (VR) environment, biometric feedback, or other pertinent input.

The machine may utilize one or more connections to one or more remote machines, such as through a network interface, modem, or other communicative coupling. Machines can be interconnected by way of a physical and/or logical network, such as an intranet, the Internet, local area networks, wide area networks, etc. One having ordinary skill in the art will appreciate that network communication may utilize various wired and/or wireless short range or long range carriers and protocols, including radio frequency (RF), satellite, microwave, Institute of Electrical and Electronics Engineers (IEEE) 545.11, Bluetooth, optical, infrared, cable, laser, etc.

Examples provide a method for producing a plurality of data samples at a predetermined sample period where each data sample represents an average of as many analog-to-digital converter (ADC) samples K that can be taken within the predetermined sample period, the method comprising: determining the number of ADC samples averaged (K), wherein K represents an integer truncation of a ratio of the predetermined sample period to a minimum ADC sample period; determining the ADC samples period by dividing the predetermined sample period by the number of ADC samples averaged; spacing the start of each group of K ADC samples by the predetermined sample period; and outputting the average of each group of K ADC samples as one of the plurality of data samples.

According to some examples, there are at least two ADCs having a span of (i.e. range of different) speed versus resolution capabilities.

Some examples further comprise selecting which of the at least two ADCs to use.

According to some examples, the number of analog-to-digital converter (ADC) samples K that can be taken within the predetermined sample period comprises the predetermined sample period divided by the maximum sample rate of the ADC in use. For example, the number of analog-to-digital converter (ADC) samples K that can be taken within the predetermined sample period may be an integer multiple of what the hardware can achieve. ADC samples may be an ADC sample reading or ADC measurement.

In some examples, the predefined sample period is a user-requested sample period or dependent on a user-defined or user-requested sample rate.

Thus, for example, implementations of the disclosure may produce a plurality of data samples at a (user defined) predetermined sample rate (having a corresponding predetermined sample period), by taking actual samples at a higher sampling rate (e.g. at the maximum sampling rate of an ADC used in the implementation(s)) and then averaging those actual samples over the user-defined predetermined sample period, to provide higher accuracy data samples at the user defined predetermined sample rate.

Examples may provide a method of producing a plurality of ADC data samples at a user-defined predetermined sample rate, having a predefined sample period, comprising receiving the user-defined predetermined sample rate from a user, determining a maximum sampling rate of an ADC in use, determining a number of actual measurements possible by the ADC during the predetermined sample period, sampling an input signal at the maximum sampling rate of the ADC to provide a set of actual data sampling measurements of the input signal, and averaging the actual data sampling measurements of the input signal using the number of actual measurements possible by the ADC during a predetermined sample period, to provide an output for each of the plurality of ADC data samples comprising an average of the actual data sampling measurements over the predefined sample period.

In some examples, determining a number of actual measurements possible by the ADC during the predetermined sample period comprises dividing the predetermined sample period by a higher sample rate possible by the ADC in use, or the maximum sample rate of the ADC in use.

In some examples, the method comprises triggering the ADC at the higher or maximum sample rate, to provide a plurality of sub-measurements, wherein the sub-measurements are separated by a first time period, having B system clocks. In some examples, the predetermined sample period comprises an integer number, K, of sub-measurements separated by the first time period, and further comprising a single final second time period having E clocks after a final sub-measurement in the predetermined sample period. In some examples, each sub-measurement takes a third time period, comprising M clocks to complete.

In some examples, the method comprises setting a first value to N, wherein N is a user defined number of measurements (i.e. related to the user defined sample period/rate), and setting a second value to K, where K is a number of sub-measurements per (main) measurement. In some examples, the method further comprises triggering the ADC and waiting M clocks, and testing if a value of K is equal to 1 and if not true applying a delay of B clocks and decrementing K by 1 then retriggering the ADC, in an iterative loop. In some examples, if testing if a value of K is equal to 1 is true, the method further comprises applying a delay of E clocks and then testing if N equals to 1, and if true, ending the method, but if not true, comprises decrementing N by 1, and then resetting the value of K to the number of sub-measurements per (main) measurement, and then retriggering the ADC, in an iterative loop. In some example, the number of (main) measurements is N, and may be defined by the user-requested sample rate. According to these examples, the method may ensure K sub-measurements are carried out per user defined predetermined sample period, for example derived from 1 divided by N.

In some examples, the method may further comprise dividing the predetermined sample period by the maximum sample rate of the ADC in use to provide an integer multiple, dividing the predetermined sample period by the integer multiple to provide an adapted sample period, and triggering the ADC to sample at an adapted sample rate. The adapted sample rate may be 1/the adapted sample period.

Examples provide an electronic acquisition system configured to carry out any of the disclosed methods.

Examples provide a computer readable medium comprising a plurality of executable instructions, which, when executed by one or more processors, causes the one or more processors to carry out any of the disclosed methods.

Having described and illustrated the principles of the invention with reference to illustrated embodiments, it will be recognized that the illustrated embodiments may be modified in arrangement and detail without departing from such principles, and may be combined in any desired manner. And although the foregoing discussion has focused on particular embodiments, other configurations are contemplated.

In particular, even though expressions such as "according to an embodiment of the invention" or the like are used herein, these phrases are meant to generally reference embodiment possibilities, and are not intended to limit the invention to particular embodiment configurations. As used herein, these terms may reference the same or different embodiments that are combinable into other embodiments.

Consequently, in view of the wide variety of permutations to the embodiments that are described herein, this detailed description and accompanying material is intended to be illustrative only, and should not be taken as limiting the scope of the invention. What is claimed as the invention, therefore, is all such modifications as may come within the scope and spirit of the following claims and equivalents thereto.

## Claims

1. A method for producing a plurality of data samples at a predetermined sample period where each data sample represents an average of as many analog-to-digital converter, ADC, samples K that can be taken within the predetermined sample period, the method comprising:
determining the number of ADC samples averaged K, wherein K represents an integer truncation of a ratio of the predetermined sample period to a minimum ADC sample period;
determining the ADC sample period by dividing the predetermined sample period by the number of ADC samples averaged;
spacing a start of each of a group of K ADC samples by the predetermined sample period; and
outputting an average of each group of K ADC samples as one of the plurality of data samples.

2. The method of claim 1, wherein there are at least two ADCs having a span of speed versus resolution capability.

3. The method of claim 2, further comprising selecting which of the at least two ADCs to use.

4. An electronic acquisition system configured to carry out any of method claims 1 to 3.

5. A computer readable medium comprising a plurality of executable instructions, which, when executed by one or more processors, causes the one or more processors to carry out any of method claims 1 to 3.
